# FASCICULE DE BREVET EUROPEEN

(11) **EP 0 705 499 B1**
(45) Date de publication et mention de la délivrance du brevet: **15.10.1997**
(21) Numéro de dépôt: 94913641.0
(22) Date de dépôt: 13.04.1994
(51) Int. Cl.: H03F 1/32, H03F 1/02

(54) **DISPOSITIF D'AMPLIFICATION DE SIGNAUX DE TELEVISION A CLASSE DE FONCTIONNEMENT VARIABLE, PREDETERMINEE POUR L'ELIMINATION DES ERREURS DE TRANSMISSION**
FERNSEHSIGNALVERSTÄRKUNGSEINRICHTUNG MIT VERÄNDERLICHER VORBESTIMMTER BETRIEBSKLASSE ZUR BESEITIGUNG VON ÜBERTRAGUNGSFEHLERN
DEVICE FOR AMPLIFYING TELEVISION SIGNALS WITH A PREDETERMINED VARIABLE OPERATING CLASS FOR PREVENTING TRANSMISSION ERRORS

(30) Priorité: 13.04.1993 FR 9304312
(43) Date de publication de la demande: 10.04.1996
(73) Titulaire: THOMCAST, 78700 Conflans-Sainte-Honorine (FR)
(72) Inventeur: CLUNIAT, Claude, F-92402 Courbevoie Cédex (FR)
(74) Mandataire: Lincot, Georges
(86) Numéro de dépôt international: FR9400412
(87) Numéro de publication internationale: WO9424760

(56) Documents cités:
- EP-A- 0 390 360
- DE-A- 3 020 313
- GB-A- 2 239 755

## Description

La présente invention telle qu'elle est définie dans les revendications concerne un dispositif d'amplification de signaux de télévision à classe de fonctionnement variable et prédéterminée pour l'élimination des erreurs de transmission. Le document EP-A-0 390 360 divulgue un exemple d'un tel dispositif.

Elle s'applique notamment à la réalisation d'émetteurs de télévision devant transmettre des signaux de standards très différents : standards analogiques actuels et numériques futurs.

Dans les réalisations actuelles des émetteurs de télévision deux types d'amplification sont en général utilisés. Un premier type concerne l'amplification dite "séparée" composée de deux ou trois voies, une pour l'image et une ou deux voies pour la transmission du son. Un second type concerne d'amplification dite "commune" qui se compose d'une seule voie pour transmettre l'image et le son. Pour ce deuxième type d'amplification les contraintes concernant la retransmission du signal sont généralement sévères car il est important que les distorsions du signal provoquées par les non-linéarités du dispositif d'amplification soient très faibles pour que la transmission du signal de télévision ne soit pas affectée par du bruit au niveau de l'image et par des transmodulations du signal d'image sur les voies sons et inversement. Cependant quelque soient ces deux types d'amplification il est important que l'émetteur de télévision ainsi réalisé soit transparent pour le standard de télévision à transmettre. En effet quelque soit le standard, PAL, SECAM, NTSC, il est très important que le signal de sortie soit un reflet fidèle du signal qui est appliqué à l'entrée des dispositifs d'amplification de l'émetteur et ceux-ci ne doivent donc pas apporter de perturbations telles que des compressions dues à des non-linéarités.

Dans le cas de l'amplification commune, il est généralement préféré de polariser l'amplificateur de puissance en classe A de façon à rendre minimum les intermodulations à faible niveau, car dans ce cas les dispositifs de correction par prédistorsion sont assez simples à réaliser et consistent simplement à effectuer une dilatation à fort niveau puisque les bas niveaux sont transmis fidèlement. Cependant le désavantage bien connu de cette classe d'amplification est qu'elle présente un rendement en puissance faible de l'ordre de 20 à 25% au maximum ce qui conduit à des consommations de courant électrique prohibitives pour des émetteurs de très forte puissance

Des études récentes ont cependant montrées qu'il était possible de précorriger des système d'amplification de type classe AB par une double correction des bas niveaux et des forts niveaux y compris dans le type d'amplification commune par un seul étage d'amplification. Cependant ceci ne convient évidemment pas lorsque pour optimiser le rendement de la voie d'amplification il est nécessaire de placer deux ou trois étages en classe AB en série. Dans ce cas le niveau d'intermodulation du signal de télévision est alors de l'ordre de 40 dB, niveau prohibitif en présence d'images et de sons, et les niveaux de distorsion cumulés des trois étages composés de trois distorsions à bas niveaux et de trois distorsions à hauts niveaux deviennent trop importants pour être corrigés jusqu'au niveau de 62 dB nécessaire pour la transmission du double son. Ces considérations imposent d'utiliser une amplification séparée pour éviter les limitations provenant de ces phénomènes, en acceptant une intermodulation de 40 dB, niveau suffisant pour une voie image seule qui peut être obtenu aisément avec une stabilité correcte.

Cependant pour la transmission des signaux de télévision dans les nouveaux standards numériques de télévision haute définition (HDTV), il apparaît que plus le type de codage du canal est évolué plus celui-ci exige une caractéristique de transfert constante lors de l'amplification de puissance ce qui impose d'utiliser des techniques de linéarisation efficaces. Si un mode de polarisation classe B/BC peut convenir efficacement pour un type de modulation numérique QPSK par exemple ce type de polarisation ne convient déjà plus pour des modulations type PAUNTSC à 16QAM, ou PAL/NTSC et encore moins pour des types de modulation à 64QAM qui nécessitent d'utiliser des amplificateurs polarisés en classe A pour le type de fonctionnement ultra linéaire en amplification commune.

Ainsi il n'est pas possible actuellement avec un seul émetteur de pouvoir satisfaire l'ensemble des services de transmission de signaux de télévision dans des standards différents.

Le but de l'invention est de pallier les inconvénients précités.

A cet effet l'invention a pour objet un dispositif d'amplification de signaux de télévision à classe de fonctionnement variable prédéterminée pour l'élimination des erreurs de transmission de signaux de télévision numériques caractérisé en ce qu'il comprend un amplificateur couplé à un circuit de commande de déplacement du point de polarisation de l'amplificateur en fonction du standard des signaux de télévision appliqués à l'entrée de l'amplificateur, du courant moyen d'alimentation de l'amplificateur et du bruit hors bande.

L'invention a pour principal avantage qu'elle permet de réaliser des émetteurs de télévision compatibles et optimisés pour les standards actuels et pour les futurs standards de télévision. Elle permet également d'optimiser les performances de ces émetteurs en fonction de chaque type de modulation en privilégiant notamment les performances des standards actuels en optimisant le rendement du système d'amplification dans chacun des standards d'utilisation. En transmission numérique elle permet d'optimiser le taux d'erreur bit (TEB) pour une prédétermination de la classe de fonctionnement,. de minimiser le taux d'erreur bit (TEB) en sortie et en entrée d'amplification grâce à un rebouclage d'asservissement sur ce taux d'erreur.

D'autres caractéristiques et avantages de l'invention apparaîtront dans la description qui suit faite en regard des figures des dessins annexés qui représentent:
- La figure 1 un amplificateur de signaux de télévision à classe de fonctionnement variable en fonction du standard des signaux de télévision à transmettre selon l'invention.
- La figure 2 un tableau indiquant les points de fonctionnement d'un émetteur fonctionnant dans les standards 4PSK, 16QAM et 64QAM.
- La figure 3 un deuxième mode de réalisation de l'amplificateur de la figure 1 muni d'un dispositif d'optimisation du taux d'erreur par choix automatique de la classe de fonctionnement.
- La figure 4 un troisième mode de réalisation du dispositif d'amplification selon la figure 1 muni d'un dispositif d'optimisation des taux d'erreur par choix automatique de la classe de fonctionnement et du niveau de précorrection du signal de télévision.
- Les figures 5 à 8 des tableaux représentatifs de classes de polarisation d'émetteurs utilisant un dispositif d'amplification conforme à l'invention.
- La figure 9 un spectre d'émission en standard numérique 64QAM.
- La figure 10 un mode de réalisation du circuit de commande du point de polarisation représenté aux figures 1, 3 et 4.
- La figure 11 un processus de commande de déplacement du point de polarisation de l'amplificateur des figures 1, 3 et 4 sous la forme d'un organigramme.

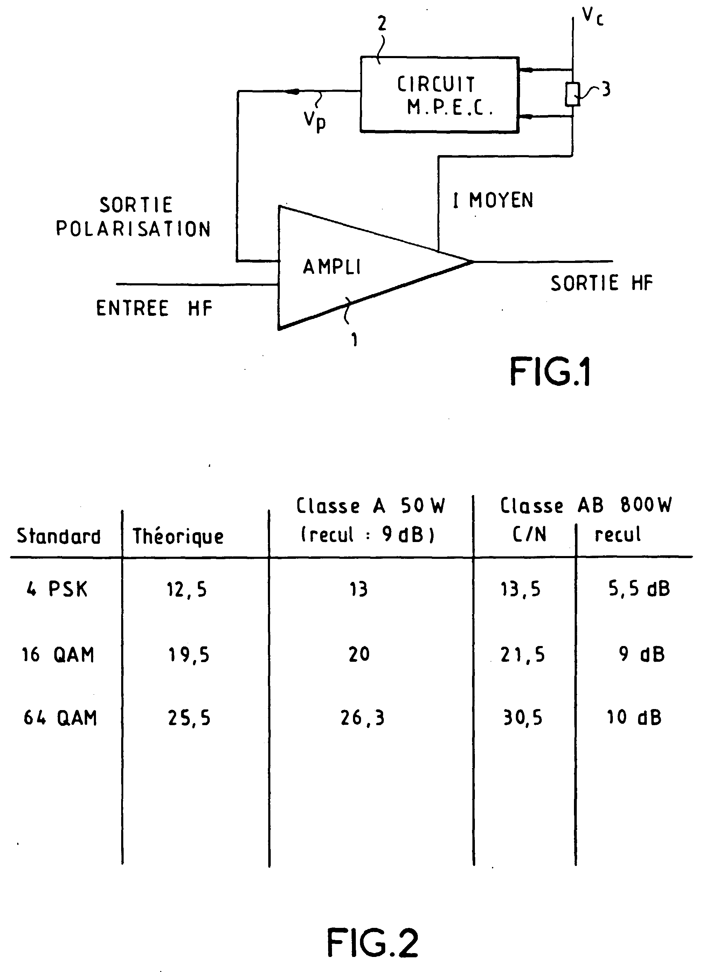

Le dispositif d'amplification selon l'invention qui est représenté à la figure 1 permet d'optimiser la classe d'amplification des amplificateurs des émetteurs de télévision en fonction de la nature du signal de télévision à transmettre. A cette fin le dispositif d'amplification représenté à la figure 1 comporte un amplificateur de signaux haute fréquence 1 couplé à un circuit 2 de commande de déplacement du point de polarisation de l'amplificateur 1. Le circuit 2 fournit un signal Vₚ de commande de polarisation de l'étage de sortie de l'amplificateur 1 en fonction du courant moyen consommé par l'amplificateur 1 qui est lui-même fonction du standard de transmission du signal de télévision en asservissant par tout dispositif connu non représenté le courant moyen consommé par l'amplificateur 1 correspondant au standard. La mesure de ce courant moyen est effectuée par le circuit 2 qui exploite la tension développée aux bornes d'une résistance 3 placée en série entre une borne d'alimentation de l'amplificateur 1 et un générateur alimentation extérieur non représenté fournissant une tension V_{c}. Dans ce mode de réalisation le circuit de commande de déplacement 2 prédéfinit les différentes classes de fonctionnement de l'amplificateur 1 en fonction des standards à transmettre. Il permet comme le montre la figure 2 par exemple des transmissions à multi-états d'amplitude en plaçant l'amplificateur 1 dans le mode de fonctionnement de classe A et en réglant la puissance moyenne de sortie à un niveau faible pour tenir compte du rendement faible de l'étage d'amplification de sortie de l'amplificateur. Pour des transmissions ne comportant que quelques états d'amplitude il permet de polariser l'amplificateur 1 en classe AB en autorisant une puissance moyenne de sortie plus élevée. Enfin pour des modes de fonctionnement à amplitude constante le circuit 2 permet de polariser l'amplificateur 1 en classe BC par exemple autorisant par ce fait un mode de fonctionnement à puissance moyenne forte.

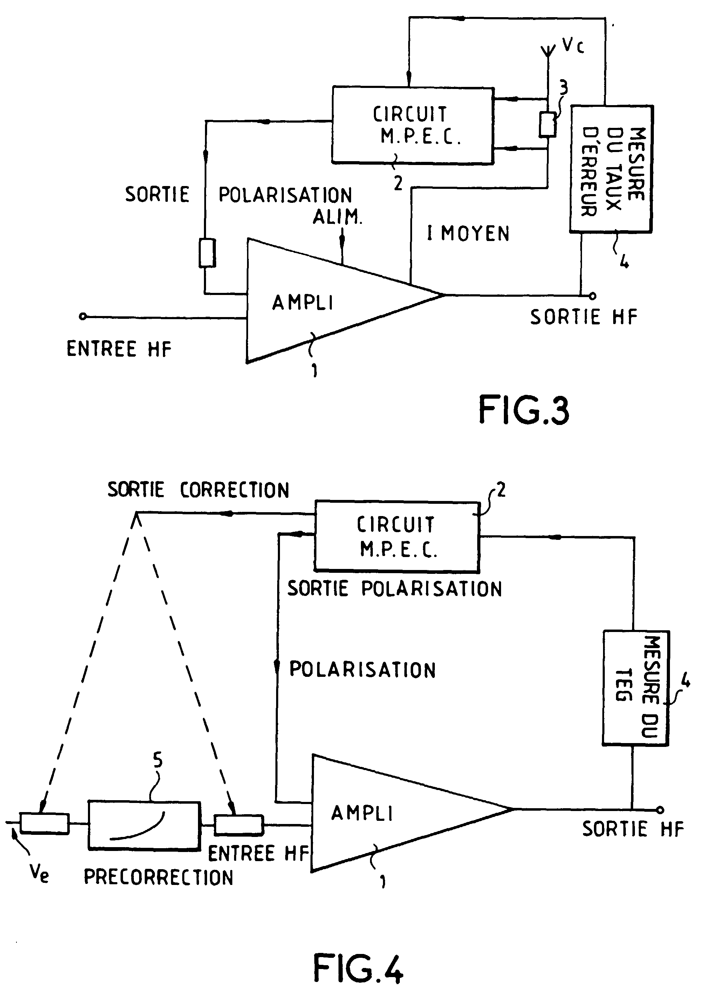

Dans le mode de réalisation de la figure 3 où les éléments homologues à ceux de la figure 1 sont représentés avec les mêmes références le circuit de la figure 1 est complété par un circuit de mesure du taux d'erreur des informations numériques transmises par l'amplificateur 1 lorsque cet amplificateur est utilisé pour la transmission de signaux de télévision numérique. Ce circuit de mesure 4 agit directement sur le circuit de commande de déplacement du point de polarisation de l'amplificateur 2.

Enfin le circuit d'amplification de la figure 3 est complété efficacement sur la figure 4 par un circuit de précorrection 5 commandé par le circuit de commande de déplacement du point de polarisation 2.

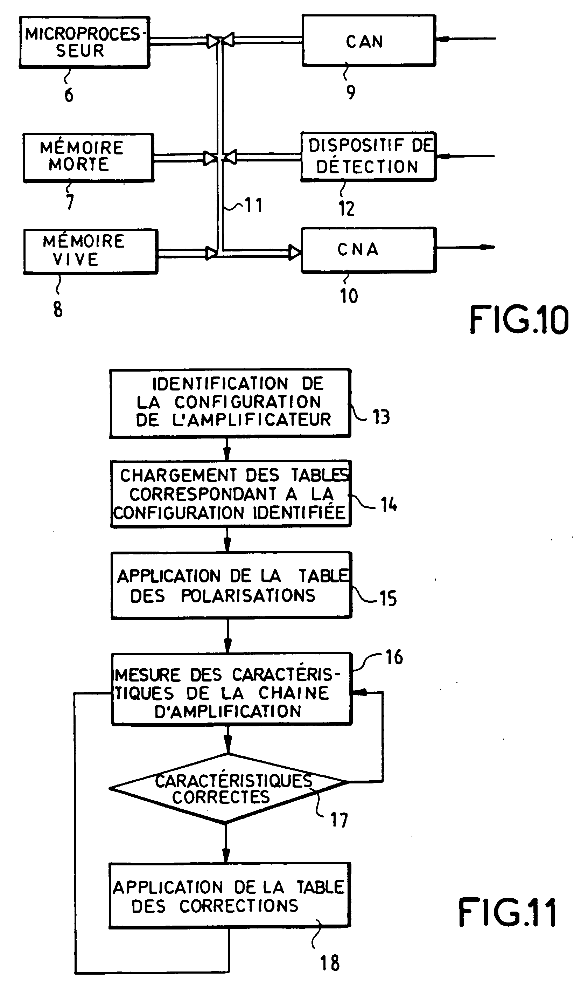

Suivant le mode de réalisation du circuit de commande de déplacement du point de polarisation 2 qui est représenté à la figure 10, celui-ci comporte un microprocesseur 6, un ensemble de mémoires mortes programmables 7, une mémoire vive 8, un circuit de conversion analogique numérique 9 et un circuit de conversion numérique analogique 10 couplés ensemble par l'intermédiaire d'un bus unique 11. Les mémoires mortes programmables 7 contiennent pour chaque type de modulation une table. Les valeurs de courant d'alimentation de l'amplificateur 3 sont appliquées à l'entrée du convertisseur analogique numérique 3 pour être quantifiées avant d'être exploitées par le microprocesseur 6 pour le calcul des valeurs de puissance moyenne et maximum fournies par l'amplificateur 3. Le circuit 2 comporte également un dispositif de détection 12 des signaux de synchronisation, du nombre de niveau de la modulation et du taux d'erreur bit.

Le microprocesseur 6 est programmé de la façon représentée à la figure 11 pour identifier la configuration de l'amplificateur en fonction des données qu'il reçoit du convertisseur analogique numérique 9 et du dispositif de détection 12 et appliquer en fonction des mesures effectuées les valeurs de correction du point de polarisation de l'amplificateur 3 par l'intermédiaire du convertisseur numérique analogique 10. Le processus commence à l'étape 13 par une identification de la configuration de l'amplificateur 3, suivi à l'étape 14 par un chargement dans la mémoire vive 8 des tables lues dans la mémoire 7 correspondant à la configuration identifiée.

Les valeurs de polarisation de l'amplificateur sont appliquées à l'étape 15. Aux étapes 16, 17 et 18 le dispositif s'autocontrôle en mesurant à l'étape 16 les caractéristiques de l'amplificateur 3 et en appliquant à l'étape 18 des valeurs de correction à l'amplificateur 3 si à l'étape 17 les caractéristiques de l'amplificateur 3 ne correspondent pas à celles attendues.

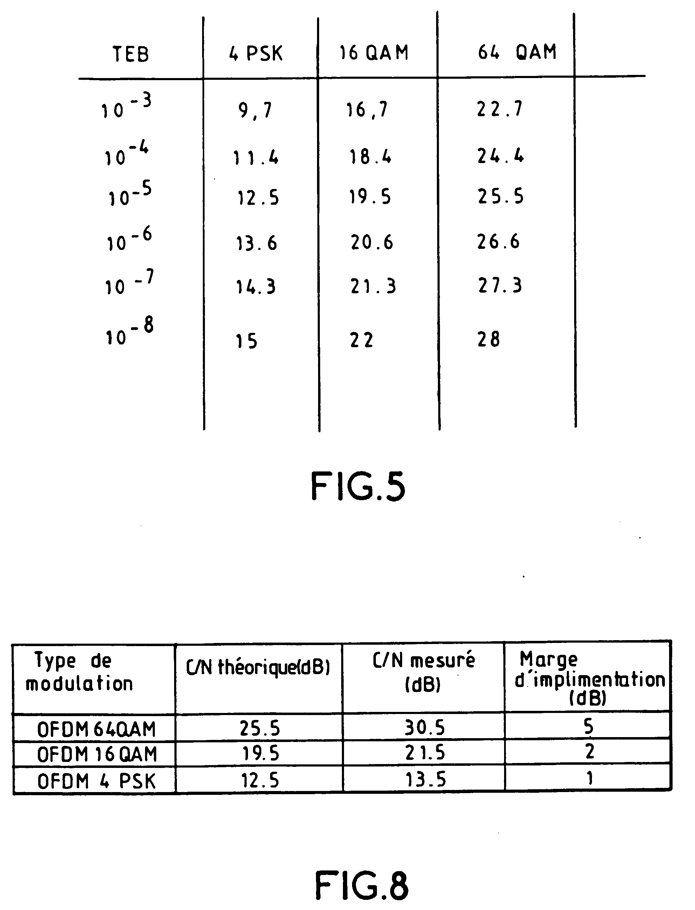

Des rapports signal/bruit à taux d'erreur bit (TEB) donné pour des modulations 4PSK, 16QAM, et 64QAM obtenus par des amplificateurs fonctionnant suivant le principe des figures 1, 3 et 4 sont consignés dans le tableau de la figure 5.

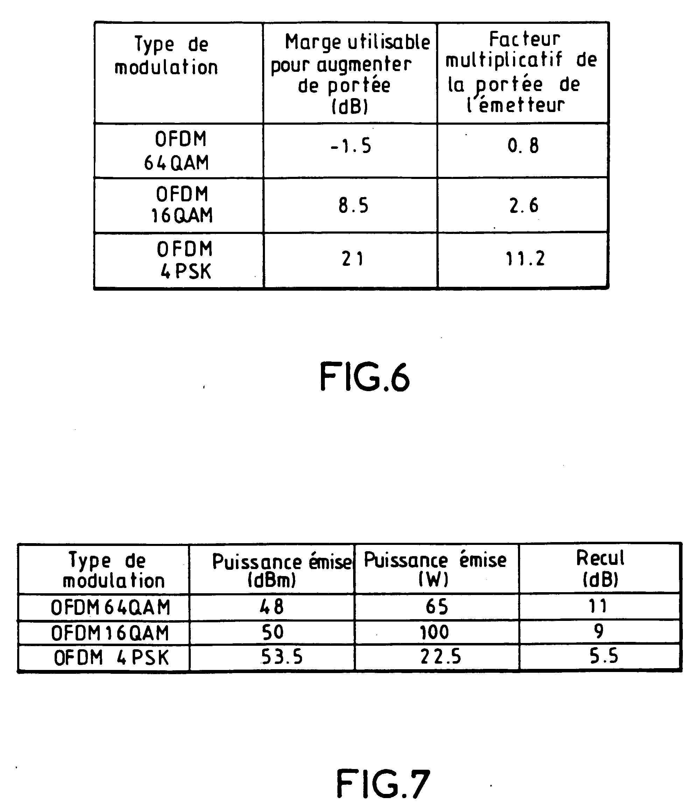

Une comparaison des caractéristiques de portée d'un émetteur fonctionnant en classe AB 800 watts en télévision classique et en télévision numérique fonctionnant en modulation OFDM incorporant des amplifications selon l'invention est montrée par le tableau de la figure 6. Dans les trois cas de modulation OFDM de la figure 6 (64QAM, 16QAM et 4PSK), la détermination de la puissance de sortie utilisable a lieu en examinant des courbes de taux d'erreur en fonction de la puissance de sortie de l'amplificateur à rapport signal à bruit constant en tolérant par exemple une dégradation du taux d'erreur bit par les non linéarités de saturation de l'amplificateur. Dans ce dernier cas les résultats obtenus sont figurés dans le tableau de la figure 7. Une marge de 1dB afin d'atténuer les non linéarités dues à la contribution du bruit blanc a été incluse.

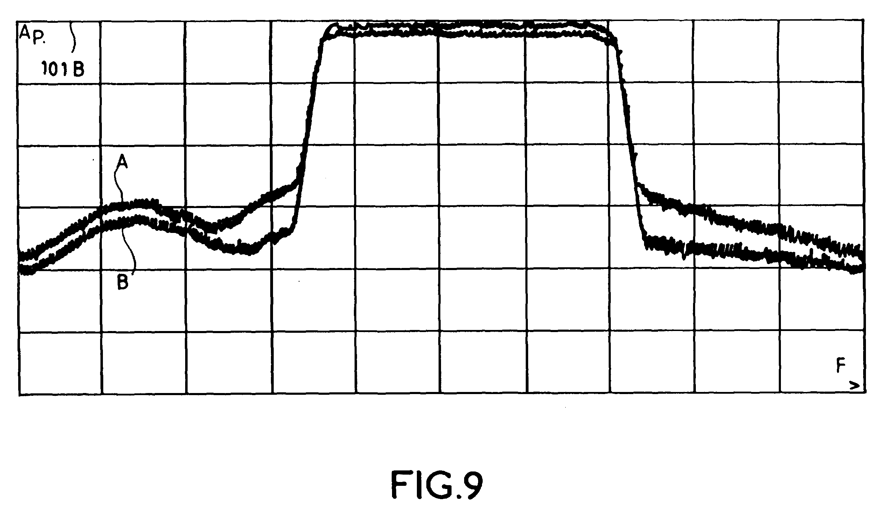

Le tableau de la figure 8 montre la marge d'implémentation à prendre en compte pour un amplificateur d'émetteur classe AB fonctionnant en modulation OFDM. Il apparaît que la marge d'implémentation à prendre en compte décroît lorsque le nombre de points de la constellation OFDM augmente.

La figure 9 montre l'effet de la correction automatique sur le spectre HF du signal transmis en standard numérique 64QAM. La mesure du taux d'erreur peut donc être remplacée avantageusement par un circuit de mesure du bruit d'intermodulation hors bande qui remplace le circuit 4 des figures 3 et 4.

La courbe A représente le spectre avant correction. La courbe B représente le spectre minimisé après correction et donc correspond à l'optimisation du taux d'erreur de transmission par des moyens automatiques.

## Revendications

1. Dispositif d'amplification de signaux de télévision à classe de fonctionnement variable prédéterminée pour l'élimination des erreurs de transmission de signaux de télévision numériques caractérisé en ce qu'il comprend un amplificateur (1) couplé à un circuit (2) de commande de déplacement du point de polarisation de l'amplificateur en fonction, du standard des signaux de télévision appliqués à l'entrée de l'amplificateur, du courant moyen d'alimentation de l'amplificateur (1) et du bruit hors bande.

2. Dispositif selon la revendication 1 caractérisé en ce qu'il comprend un circuit de mesure (4) du taux d'erreur des signaux de télévision numériques transmis par l'amplificateur, pour le déplacement du point de polarisation en fonction du taux d'erreur.

3. Dispositif selon l'une quelconque des revendications 1 et 2 caractérisé en ce qu'il comprend un circuit de mesure (4) du bruit hors bande des signaux de télévision transmis pour le déplacement du point de polarisation.

4. Dispositif selon l'une quelconque des revendications 1 à 3 caractérisé en ce qu'il comprend un dispositif de précorrection (5) du signal de télévision appliqué à l'entrée de l'amplificateur (1) commandé par le circuit de commande de déplacement du point de polarisation (2).

5. Dispositif selon l'une quelconque des revendications 1 à 4 caractérisé en ce que le circuit de commande (2) comprend un microprocesseur (6) couplé par l'intermédiaire d'un bus (11) à un ensemble de mémoires mortes programmables (7), une mémoire vive (8), un circuit de conversion analogique-numérique (9), un circuit de conversion numérique-analogique (10) et à un dispositif de détection (12) des signaux de synchronisation, du nombre de niveaux de la modulation et du taux d'erreur bit et en ce que le microprocesseur (6) est programmé pour identifier la configuration de l'amplificateur (1) en fonction des données qu'il reçoit du convertisseur analogique-numérique (9) et du dispositif détection (12) pour appliquer en fonction des mesures effectuées les valeurs de correction du point de polarisation de l'amplificateur (1) par l'intermédiaire du convertisseur numérique-analogique (10).

6. Dispositif selon la revendication 5 caractérisé en ce que dans l'ensemble de mémoires mortes programmables (7) sont mémorisées des tables d'ajustement du point de polarisation en fonction de chaque type de modulation.

## Claims

1. Television signal amplification device with variable class of operation which is predetermined in order to eliminate digital television signal transmission errors, characterized in that it comprises an amplifier (1) coupled to a circuit (2) for control of the shifting of the bias point of the amplifier depending on the standard of the television signals applied to the input of the amplifier, on the mean power supply current of the amplifier (1) and on the out-of-band noise.

2. Device according to Claim 1, characterized in that it comprises a circuit (4) for measuring the error rate in the digital television signals transmitted by the amplifier, for shifting the bias point as a function of the error rate.

3. Device according to either of Claims 1 and 2, characterized in that it comprises a circuit (4) for measuring the out-of-band noise of the transmitted television signals for shifting the bias point.

4. Device according to any one of Claims 1 to 3, characterized in that it comprises a device (5) for precorrection of the television signal applied to the input of the amplifier (1) controlled by the bias point shift control circuit (2).

5. Device according to any one of Claims 1 to 4, characterized in that the control circuit (2) comprises a microprocessor (6) coupled via a bus (11) to a set of programmable read-only memories (7), a random-access memory (8) an analogue-digital conversion circuit (9), a digital-analogue conversion circuit (10) and to a device (12) for detecting synchronization signals, the number of levels of the modulation and the bit error rate, and in that the microprocessor (6) is programmed to identify the configuration of the amplifier (1) on the basis of data which it receives from the analogue-digital converter (9) and from the detection device (12) in order, on the basis of the measurements performed, to apply the values for correcting the bias point of the amplifier (1) via the digital-analogue converter (10).

6. Device according to Claim 5, characterized in that, in the set of programmable read-only memories (7) are stored tables for adjusting the bias point depending on each type of modulation.

## Patentansprüche

1. Anordnung zur Verstärkung von Fernsehsignalen einer vorgegebenen, variablen Betriebsklasse zur Beseitigung von Übertragungsfehlern in digitalen Fernsehsignalen, dadurch gekennzeichnet, daß sie einen Verstärker (1) enthält, der an eine Schaltung (2) für die Steuerung der Verschiebung des Vorspannungspunkts des Verstärkers in Abhängigkeit von der Norm der an den Eingang des Verstärkers angelegten Fernsehsignale, vom mittleren Speisestrom des Verstärkers (1) und vom Außerbandrauschen angeschlossen ist.

2. Anordnung nach Anspruch 1, dadurch gekennzeichnet, daß sie eine Meßschaltung (4) für den Fehleranteil der vom Verstärker übertragenen digitalen Fernsehsignalen enthält, um den Vorspannungspunkt in Abhängigkeit vom Fehleranteil zu verschieben.

3. Anordnung nach irgendeinem der Ansprüche 1 und 2, dadurch gekennzeichnet, daß sie eine Meßschaltung (4) für das Außerbandrauschen der übertragenen Fernsehsignale enthält, um den Vorspannungspunkt zu verschieben.

4. Anordnung nach irgendeinem der Ansprüche 1 bis 3, dadurch gekennzeichnet, daß sie eine Vorkorrekturvorrichtung (5) für das an den Eingang des Verstärkers (1) angelegte Fernsehsignal enthält, die durch die Steuerschaltung (2) für die Verschiebung des Vorspannungspunkts gesteuert wird.

5. Anordnung nach irgendeinem der Ansprüche 1 bis 4, dadurch gekennzeichnet, daß die Steuerschaltung (2) einen Mikroprozessor (6), der über einen Bus (11) an eine Gruppe von programmierbaren Festwertspeichern (7) angeschlossen ist, einen Schreib-Lese-Speicher (8), eine Analog/Digital-Umsetzungsschaltung (9), eine Digital/Analog-Umsetzungsschaltung (10) sowie eine Erfassungsschaltung (12) für Synchronisationssignale, für die Anzahl der Modulationsniveaus und für den Bitfehleranteil enthält und daß der Mikroprozessor (6) so programmiert ist, daß er die Konfiguration des Verstärkers (1) in Abhängigkeit von den Daten identifiziert, die er vom Analog/Digital-Umsetzer (9) und von der Erfassungsschaltung (12) empfängt, um in Abhängigkeit von den ausgeführten Messungen die Korrekturwerte des Vorspannungspunkts des Verstärkers (1) über den Digital/Analog-Umsetzer (10) anzulegen.

6. Anordnung nach Anspruch 5, dadurch gekennzeichnet, daß in der Gruppe der programmierbaren Festwertspeicher (7) Tabellen für die Einstellung des Vorspannungspunkts in Abhängigkeit jedes Modulationstyps gespeichert sind.
